# FASCICULE DE BREVET EUROPEEN

(11) **EP 2 795 411 B1**
(45) Date de publication et mention de la délivrance du brevet: **03.11.2021**
(21) Numéro de dépôt: 12812966.5
(22) Date de dépôt: 20.12.2012
(51) Int. Cl.: G04F 5/06, G04G 17/02, B81C 1/00, G04B 17/06, G04C 3/12, G02B 6/12, B23K 26/00, G04B 17/34

(54) **PROCÉDÉ DE RÉALISATION D'UN RÉSONATEUR**
VERFAHREN ZUR HERSTELLUNG EINES RESONATORS
METHOD FOR MANUFACTURING A RESONATOR

(30) Priorité: 22.12.2011 EP 11195420
(43) Date de publication de la demande: 29.10.2014
(73) Titulaire: The Swatch Group Research and Development Ltd., 2074 Marin (CH)
(72) Inventeur: HESSLER, Thierry, 2024 St-Aubin (CH); DALLA PIAZZA, Silvio, 2610 St-Imier (CH)
(74) Mandataire: Collé, Emmanuel
(86) Numéro de dépôt international: PCT/EP2012/076498
(87) Numéro de publication internationale: WO 2013/092920

(56) Documents cités:
- EP-A1- 1 445 670
- EP-A1- 1 791 039
- EP-A1- 1 818 736
- EP-A1- 2 105 807
- EP-A1- 2 317 406
- EP-A1- 2 707 777
- WO-A1-2011/154701
- WO-A2-02/16070
- CH-B1- 702 708
- US-A1- 2002 139 769
- US-A1- 2003 235 385
- US-A1- 2007 115 079
- US-A1- 2011 034 031
- US-A1- 2011 127 883

## Description

L'invention concerne un résonateur comportant un corps utilisé en déformation comme un résonateur spiral ou un diapason.

### ARRIERE PLAN TECHNOLOGIQUE

Il est connu de l'art antérieur que certaines pièces de microtechnique en matériaux de type monocristallin ou polycristallin, comme des résonateurs, sont réalisées par gravure chimique. Cette technique consiste à se munir du substrat à graver et à déposer une couche de résine photosensible dessus. Sur cette résine est placé un masque puis le tout est exposé à de la lumière afin que la structure de la résine photosensible exposée à la lumière soit modifiée. Cette résine modifiée est éliminée par action d'un élément chimique laissant alors à nu, aux endroits où la résine a été éliminée, le substrat.

Par la suite, ces zones à nu du substrat sont attaquées chimiquement afin de les creuser. L'agent chimique est choisi pour attaquer seulement le matériau composant le substrat et non la résine photosensible non modifiée. La durée de cette étape de gravure chimique permet de déterminer les dimensions des creusures.

De même, il est envisageable que des pièces de microtechnique soient réalisées par usinage et/ou polissage de sorte qu'un foret ou une polisseuse puissent être utilisés pour façonner lesdites pièces.

Un premier inconvénient de cette technique de gravure chimique est qu'elle ne permet pas de réaliser des creusures avec des flancs droits. En effet, les creusures obtenues présentent des flancs inclinés. On entend par là que la surface de la creusure varie en fonction de la profondeur c'est-à-dire que cette surface s'agrandit ou se rétrécit au fur et à mesure que la creusure devient profonde. Généralement cette surface rétrécit avec la profondeur. Cette constatation oblige à adapter les calculs théoriques réalisés pour obtenir des creusures à flancs droits. De plus, cette variation du profil des creusures entre la théorie et la pratique entraîne une variation des caractéristiques.

Le document EP 1 791 039 A1 divulgue la fabrication d'un résonateur spiral par la modification de la structure d'une plaque de substrat en verre 1. La modification de certaines zones du substrat en verre a lieu avec un laser UV puis le substrat est gravé dans une solution chimique pour fabriquer les spires.

### RESUME DE L'INVENTION

L'invention a pour but de pallier aux inconvénients cités ci-devant en proposant un procédé de fabrication permettant de réaliser un composant comprenant des creusures dont les flancs ont une inclinaison facilement réalisable.

A cet effet, l'invention concerne un procédé de fabrication d'un résonateur spiral dans un substrat selon la revendication 1.,

Un avantage de la présente invention est de permettre de réaliser des évidements se situant sous la surface car le matériau utilisé est choisi comme étant transparent pour le laser. Cela permet au laser de pouvoir pointer n'importe quel point de la surface ou sous la surface du résonateur. Le matériau est alors rendu sélectif de sorte que l'attaque chimique qui suit n'opère que sur le matériau ayant subit une modification par le laser. On obtient alors un procédé qui permet de réaliser des évidements complexes et internes.

Des modes de réalisation avantageux du procédé selon la présente invention font l'objet de revendications dépendantes.

Dans un mode de réalisation avantageux, le procédé comprend en outre l'étape :
c) libérer le composant dudit substrat.

Dans un mode de réalisation avantageux, la structure de ladite au moins une zone est modifiée par un laser dont la durée des impulsions est de l'ordre de la femtoseconde.

Dans un mode de réalisation avantageux, le substrat est réalisé en matériau monocristallin.

Dans un autre mode de réalisation avantageux, le substrat est réalisé en matériau polycristallin.

Dans un autre mode de réalisation avantageux, le substrat est réalisé en un matériau amorphe comme une céramique ou un verre.

Dans un autre mode de réalisation avantageux, le substrat est réalisé en polymère.

Dans un mode de réalisation, qui ne fait pas partie de l'invention, le composant est un résonateur comprenant une base à partir de laquelle s'étendent au moins deux bras parallèles présentant chacun une face supérieure et une face inférieure et comprenant en outre au moins un évidement réalisé sur l'une des faces de l'un des au moins deux bras parallèles.

Dans un autre mode de réalisation avantageux, ledit au moins un évidement se présente sous la forme d'une gorge ayant au moins un de ses flancs verticaux.

Dans un mode de réalisation, qui ne fait pas partie de l'invention, ledit résonateur comprend une gorge par bras.

Dans un mode de réalisation, qui ne fait pas partie de l'invention, ledit résonateur comprend une gorge sur la face supérieure de chaque bras et une gorge sur la face inférieure de chaque bras.

Dans un mode de réalisation, qui ne fait pas partie de l'invention, ledit résonateur comprend deux gorges par bras.

Dans un mode de réalisation, qui ne fait pas partie de l'invention, ledit résonateur comprend deux gorges sur la face supérieure de chaque bras et deux gorges sur la face inférieure de chaque bras.

Dans un autre mode de réalisation avantageux, il comprend en outre une étape consistant à modifier la structure du résonateur par laser de sorte à modifier localement l'indice de réfraction de la matière.

Selon l'invention, le composant est un résonateur comprenant un volant d'inertie couplé à un corps formé d'un barreau enroulé sur lui-même pour former un spiral, ledit corps comprenant au moins une creusure pour modifier localement la rigidité et ainsi ajuster la fréquence du résonateur et/ou régler le défaut d'isochronisme.

Dans un autre mode de réalisation avantageux, ladite au moins une creusure comprend au moins deux flancs parallèles et verticaux.

Dans un autre mode de réalisation avantageux, ledit corps est réalisé en quartz ou céramique ou verre et en ce qu'il comprend des flancs localement parallèles et verticaux sur toute la longueur dudit corps.

Dans un autre mode de réalisation avantageux, ledit corps comprend une courbe terminale élevée par rapport aux autres spires formées par le barreau enroulé sur lui-même

Dans un autre mode de réalisation avantageux, ledit corps transmet et diffuse de la lumière émise par au moins une source d'énergie lumineuse.

Dans un autre mode de réalisation avantageux, la structure dudit corps est modifiée par laser de sorte à modifier localement l'indice de réfraction de la matière.

Dans un autre mode de réalisation avantageux, la structure dudit corps dont l'indice de réfraction de la matière est modifié par laser est utilisée pour former un miroir.

Dans un autre mode de réalisation avantageux, la structure dudit corps dont l'indice de réfraction de la matière est modifié par laser est utilisée pour former un guide de lumière.

Dans un mode de réalisation, qui ne fait pas partie de l'invention, un résonateur comprend une base à partir de laquelle s'étendent au moins deux bras parallèles présentant chacun une face supérieure et une face inférieure, et au moins un groupe d'électrodes situé sur un des au moins deux bras parallèles pour exciter électriquement lesdits au moins deux bras parallèles, caractérisé en ce qu'il comprend au moins deux flancs parallèles droits.

Dans un mode de réalisation, qui ne fait pas partie de l'invention, l'une des faces de l'un des au moins deux bras parallèles comprend au moins un évidement se présentant sous la forme d'une gorge présentant des flancs verticaux.

Dans un mode de réalisation, qui ne fait pas partie de l'invention, ledit résonateur comprend une gorge par bras.

Dans un mode de réalisation, qui ne fait pas partie de l'invention, ledit résonateur comprend une gorge sur la face supérieure de chaque bras et une gorge sur la face inférieure de chaque bras.

Dans un mode de réalisation, qui ne fait pas partie de l'invention, ledit résonateur comprend deux gorges par bras.

Dans un mode de réalisation, qui ne fait pas partie de l'invention, ledit résonateur comprend deux gorges sur la face supérieure de chaque bras et deux gorges sur la face inférieure de chaque bras.

Dans un mode de réalisation, qui ne fait pas partie de l'invention, les gorges comprennent une saillie qui permet d'optimiser les champs électriques, tout en augmentant les tolérances d'alignement.

Dans un autre mode de réalisation avantageux, la totalité des flancs dudit résonateur sont droits et verticaux.

Dans un autre mode de réalisation avantageux, la totalité des angles dudit résonateur sont droits.

Dans un autre mode de réalisation avantageux, la totalité des flancs dudit résonateur sont droits.

L'invention concerne également un résonateur spiral selon la revendication 17.

Dans un mode de réalisation avantageux, ladite au moins une creusure comprend au moins deux flancs parallèles.

Dans un mode de réalisation avantageux, ledit corps comprend une courbe terminale élevée par rapport aux autres spires formées par le barreau enroulé sur lui-même

Dans un mode de réalisation avantageux, ledit corps transmet et diffuse de la lumière émise par au moins une source d'énergie lumineuse.

Dans un mode de réalisation avantageux, la structure dudit corps est modifiée par laser de sorte à modifier localement l'indice de réfraction de la matière.

Dans un mode de réalisation avantageux, la structure dudit corps dont l'indice de réfraction de la matière est modifié par laser est utilisée pour former un miroir.

Dans un mode de réalisation avantageux, la structure dudit corps dont l'indice de réfraction de la matière est modifié par laser est utilisée pour former un guide de lumière.

Dans un mode de réalisation avantageux, le résonateur comprend en outre une virole venant de matière avec ledit corps, ladite virole comprend un trou agencé pour que ledit résonateur soit monté sur un axe, en ce que le trou présente au moins un flanc sur lesquels au moins une gorge est agencée de sorte qu'un élément intermédiaire puisse s'insérer entre la virole et l'axe.

### BREVE DESCRIPTION DES FIGURES

Les buts, avantages et caractéristiques du procédé selon la présente invention apparaîtront plus clairement dans la description détaillée suivante de formes de réalisation de l'invention données uniquement à titre d'exemple non limitatif et illustrées par les dessins annexés sur lesquels :
- Les figures 1 et 2 représentent de manière schématique une vue de face d'un résonateur selon l'art antérieur ;
- Les figures 3a à 3e représentent de manière schématique les étapes d'un procédé, qui ne fait pas partie de l'invention,;
- Les figures 4 et 5 représentent de manière schématique une première forme d'exécution d'un résonateur, qui ne fait pas partie de l'invention;
- La figure 6 représente de manière schématique une variante de la première forme d'exécution d'un résonateur, qui ne fait pas partie de l'invention ;
- La figure 7 représente de manière schématique une deuxième forme d'exécution d'un résonateur, qui ne fait pas partie de l'invention;
- Les figures 8 et 9 représentent de manière schématique une première variante de la seconde forme d'exécution d'un résonateur, qui ne fait pas partie de l'invention;
- La figure 10 représente de manière schématique une seconde variante de la seconde forme d'exécution d'un résonateur, qui ne fait pas partie de l'invention;
- La figure 11 représente de manière schématique une troisième forme d'exécution d'un résonateur, qui ne fait pas partie de l'invention;
- La figure 12 représente de manière schématique une variante de la première forme d'exécution d'un résonateur, qui ne fait pas partie de l'invention;
- La figure 13 représente de manière schématique la partie spirale du résonateur spiral selon la présente invention.
- La figure 14 et 15 représentent de manière schématique des variantes de la partie spirale du résonateur spiral selon la présente invention.
- La figure 16 représente de manière schématique la partie fixation du résonateur spiral selon la présente invention.

### DESCRIPTION DETAILLEE

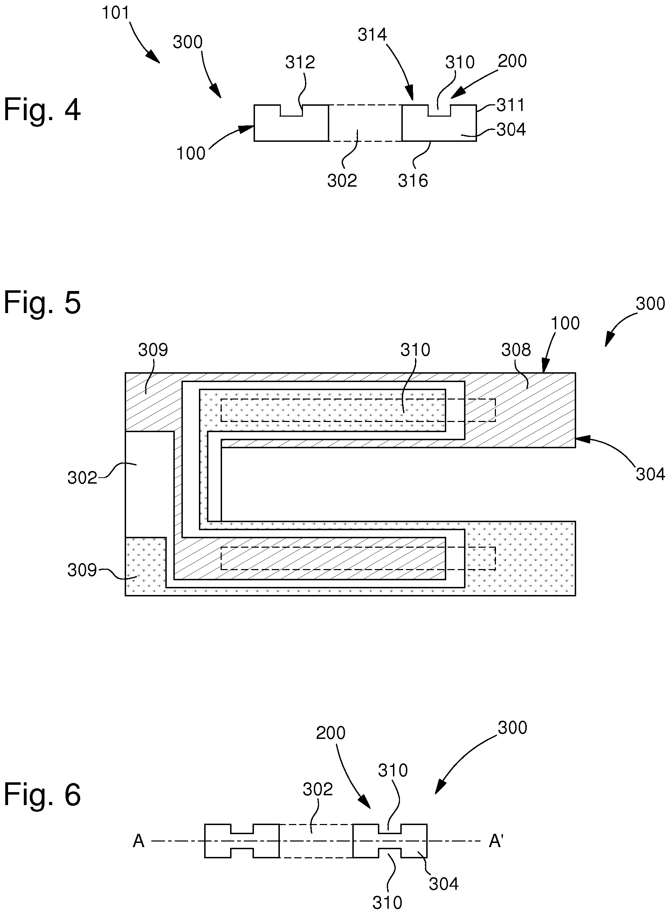

Les figures 4 et 5 représentent de manière schématique un composant, qui ne fait pas partie de l'invention.

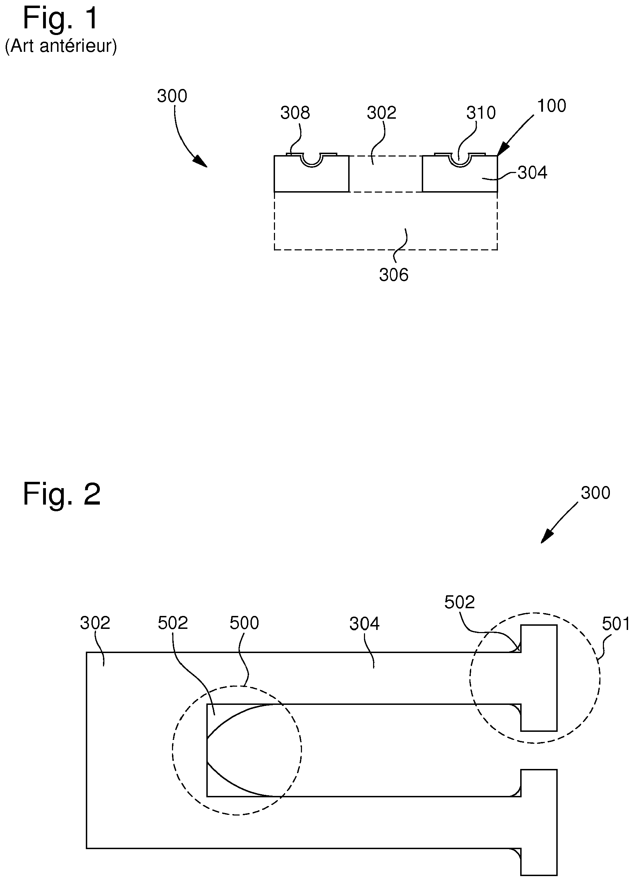

Le composant 101 fabriqué avec le procédé, qui ne fait pas partie de l'invention, est un résonateur 300. Un résonateur classique visible à la figure 1 comprend un corps 100 utilisé en déformation. Ce corps 100 prend la forme d'une base 302 posée sur un socle 306 et à partir de laquelle s'étendent au moins deux bras parallèles 304. Ces deux bras parallèles 304 portent des métallisations qui forment, sur ces branches, deux groupes d'électrodes 308 qui permettent de les soumettre à des champs électriques pour les faire vibrer. Le résonateur 300 comprend en outre, sur la base 302, des plages de connexion 309 reliées respectivement aux groupes d'électrodes 308 comme visible à la figure 5. Chaque bras 304 comprend une face supérieure 314 et une face inférieure 316. Les dimensions typiques d'un tel résonateur 300 sont une longueur de 1mm, une largeur de 0.1 mm et une épaisseur de 0.1mm, Le résonateur comprend en outre des flancs 311.

Afin d'améliorer les caractéristiques du résonateur 300, il est connu de réaliser des évidements 200 se présentant sous la forme de gorges 310 ou rainures et situés sur ces bras 304. Ces gorges 310 augmentent le couplage piézoélectrique, ce qui permet une diminution de la consommation électrique. Cette diminution de la consommation est une conséquence de la diminution de la résistance électrique représentant les pertes dans le schéma équivalent du résonateur 300.

Pour réaliser les gorges 310 du composant 101, on se propose de fournir un procédé de fabrication. Dans le cas présent, l'accent sera mis sur la réalisation des gorges 310 ou évidements 200.

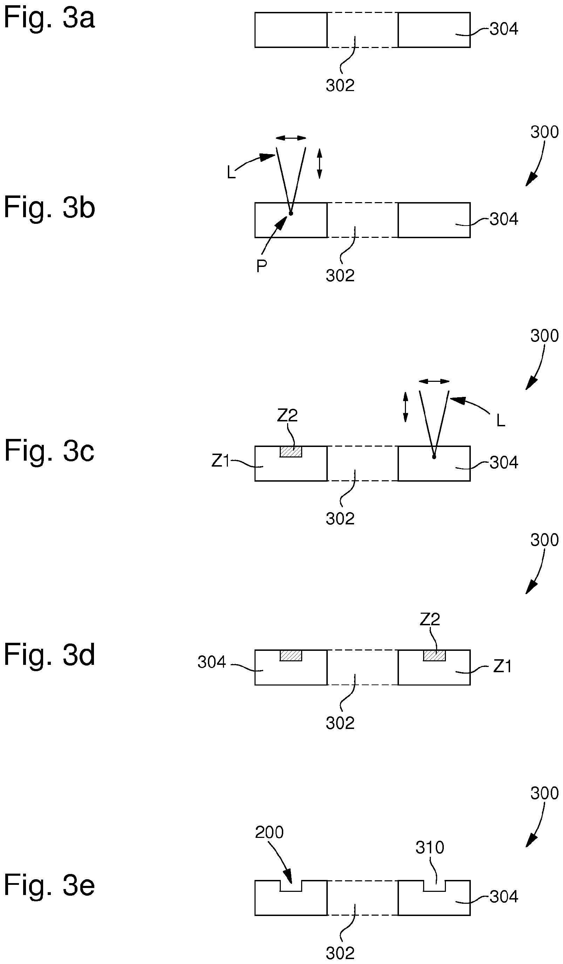

Dans une première étape représentée à la figure 3a, on se munit du composant 101, ici le résonateur 300, sans que les gorges 310 ne soient réalisées. On comprend alors que ce résonateur 300 est préalablement réalisé. Ce résonateur 300 est réalisé selon la méthode la plus appropriée en fonction du matériau le constituant, appelé ici premier matériau, comme par exemple l'usinage ou la gravure chimique.

Une seconde étape consiste à se munir d'un laser (L) dont la durée des impulsions est ici de l'ordre de la femto-seconde c'est-à-dire 10⁻¹⁵ seconde (typiquement 100 fs). La durée des impulsions peut aller de la femtoseconde à la picoseconde (10⁻¹² seconde). Ce laser (L) est ensuite utilisé afin de modifier la structure dudit bras 304 comme visible à la figure 3b. A cet effet, le premier matériau est choisi comme étant transparent pour le laser. Cela permet de pointer, avec le point de focalisation (P) du laser (L), un point (P) qui peut se trouver sur ou sous la surface du bras 304. Pour le laser (L) dont la durée des impulsions est ici de l'ordre de la femto-seconde, le premier matériau peut être un matériau monocristallin comme le quartz, le saphir ou le rubis synthétique, ou un matériau polycristallin comme le rubis polycristallin ou un matériau amorphe comme un verre tel que la silice ou une céramique. Le point de focalisation (P) est ensuite pointé en direction du résonateur 300 au niveau de zones situées sur ou sous la surface du résonateur 300. Tout cela est fait selon une séquence prédéterminée ou désirée afin de provoquer localement une modification de la structure par absorption à plusieurs photons. En effet, la modification de la structure du matériau par absorption à plusieurs photons nécessite une densité d'énergie très élevée. Or, obtenir une telle densité d'énergie nécessaire n'est actuellement possible qu'avec des lasers dont la durée des impulsions est très faible, c'est-à-dire, de l'ordre de la femto-seconde ou de la pico-seconde. Ces lasers sont, en effet, capables de fournir cette densité d'énergie au point de focalisation c'est-à-dire là ou la densité d'énergie est la plus importante. On modifie alors la structure d'un premier bras 304 comme visible à la figure 3c et on s'occupe de l'autre bras 304. On obtient alors le résonateur 300 tel que visible à la figure 3d.

La troisième étape consiste à se munir d'un agent chimique. Cet agent chimique est choisi pour permettre aux zones Z1 dont la structure est modifiée, d'être dissoutes plus rapidement que les zones Z2 dont la structure n'a pas été modifiée. On entend par là que la vitesse d'attaque des zones Z1 dont la structure a été modifiée par le point de focalisation (P) du laser (L) est supérieure à la vitesse d'attaque des zones Z2 dont la structure n'a pas été modifiée par le laser (L). En effet, la modification locale de la structure par le point de focalisation (P) du laser (L) femtoseconde permet de choisir un agent chimique qui est plus réactif aux zones modifiées Z1 qu'aux zones non modifiées Z2. En conséquence, en plongeant, durant un temps déterminé, ledit résonateur dans un bain composé de l'agent chimique, on fait en sorte que toutes les zones Z1 dont la structure a été modifiée par le point de focalisation (P) du laser (L) soient dissoutes. Bien entendu, les dimensions du résonateur 300 sont calculées pour prendre en compte l'attaque chimique de l'agent chimique sur les zones non modifiées et ainsi ne pas dissoudre excessivement les zones dont la structure n'est pas modifiée. On obtient alors le résonateur 300 visible à la figure 3e.

Par ailleurs, on notera que pour que la dissolution des zones Z1 dont la structure été modifiée se fasse, il est nécessaire que les zones Z1 puissent être accessibles pour l'agent chimique. On comprend donc qu'au moins une surface ou au moins une zone Z1 proche de la surface soit modifiée. En effet, le présent procédé permet de réaliser des structures internes mais nécessite que l'agent chimique puisse avoir accès aux zones Z1 dont la structure est modifiée. Avec une zone Z1 dont la structure est modifiée en surface, on permet audit agent chimique de dissoudre directement les zones modifiées Z1. Néanmoins, il est envisageable que les zones Z1 dont la structure a été modifiée ne soit pas situées à la surface mais juste sous la surface. L'agent chimique dissout alors le peu de zones Z2 non modifiées séparant ledit agent chimique des zones modifiées Z1 pour permettre ensuite la dissolution de celles-ci. Bien entendu, chaque évidement 200 du résonateur 300 devra être configuré de la sorte ou doivent être joints. Une fois toutes les zones modifiées Z1 dissoutes, ledit résonateur est sorti du bain.

Une quatrième étape consiste à nettoyer ledit résonateur afin que tous les résidus d'agent chimique soient éliminés. Cela permet que la réaction chimique soit définitivement stoppée.

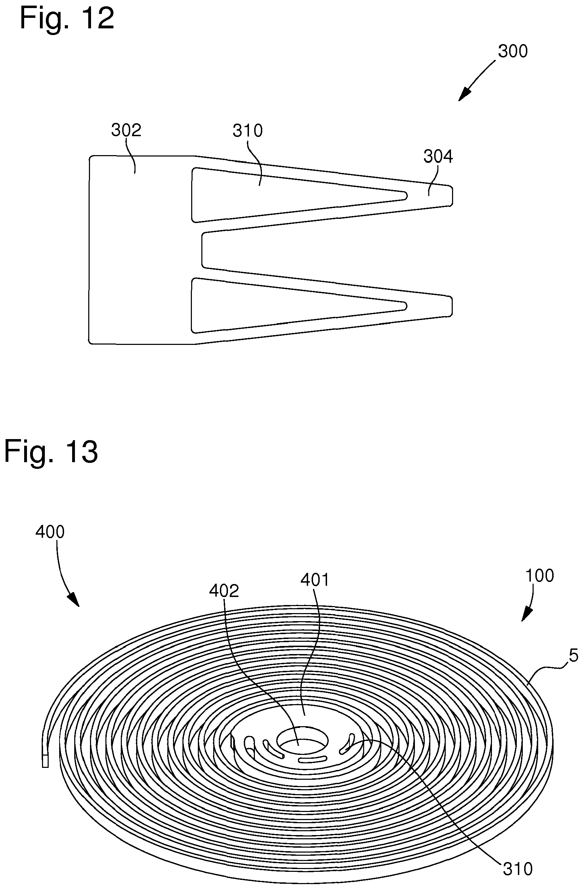

L'avantage du procédé est double. En effet, ce procédé permet de modifier localement la structure du matériau du composant de sorte que chaque endroit en surface ou sous la surface du composant peut être structurellement modifié. Il est donc possible de modifier structurellement le résonateur 300 selon des formes complexes qui seront gravées chimiquement de façon précise. Par exemple, il est envisageable d'avoir des bras de forme trapézoïdale comme visible à la figure 12.

Cette possibilité de formes complexes est alors utilisée pour réaliser des flancs 311 et des creusures 310 ayant des flancs 312 droits et verticaux. Effectivement, les zones modifiées Z2 sont agencées pour prévoir ces flancs 312 droits et comme l'étape de gravure chimique n'agit que sur les zones modifiées, la verticalité des flancs 312 est gardée. On peut généraliser en disant que l'avantage du présent procédé est de préserver les formes d'origines des évidements 200. La présence des flancs 312 droits et verticaux permet d'améliorer le couplage piézoélectrique. En effet, ces flancs 312 entraînent une augmentation de la capacité motionnelle du résonateur 300. Or, cette capacité motionnelle représente l'efficacité du couplage piézoélectrique. Pour le résonateur 300 représenté à la figure 4, l'augmentation du gain en couplage piézoélectrique est de l'ordre de 30%.

Dans une première forme d'exécution visible aux figures 4 et 5, qui ne fait pas partie de l'invention, le résonateur reprend le modèle du résonateur 300 de l'art antérieur c'est-à-dire qu'il comprend deux gorges 310. Ces deux gorges 310 sont situées chacune sur la face supérieure 314 d'un des bras 304. Chaque bras 304 comprend alors une gorge 310. De préférence, la gorge 310 de chaque bras 304 est placée de façon centrée comme visible à la figure 4. Ces gorges 310 pouvant ainsi être de la même forme que celle des bras c'est-à-dire trapézoïdale dans le cas de la figure 12.

Dans une variante de cette première forme d'exécution, chaque face 314, 316 de chaque bras 304 comporte une gorge 310. On comprend que pour un résonateur 300 ayant deux bras 304, ledit résonateur 300 comprend quatre gorges 310. On dénombre alors une gorge 310 sur la face supérieure 314 de chaque bras 304 et une gorge 310 sur la face inférieure 316 de chaque bras 304. Dans cette variante, les gorges 310 de chaque bras 304 sont opposées par rapport au plan A-A' visible à la figure 6.

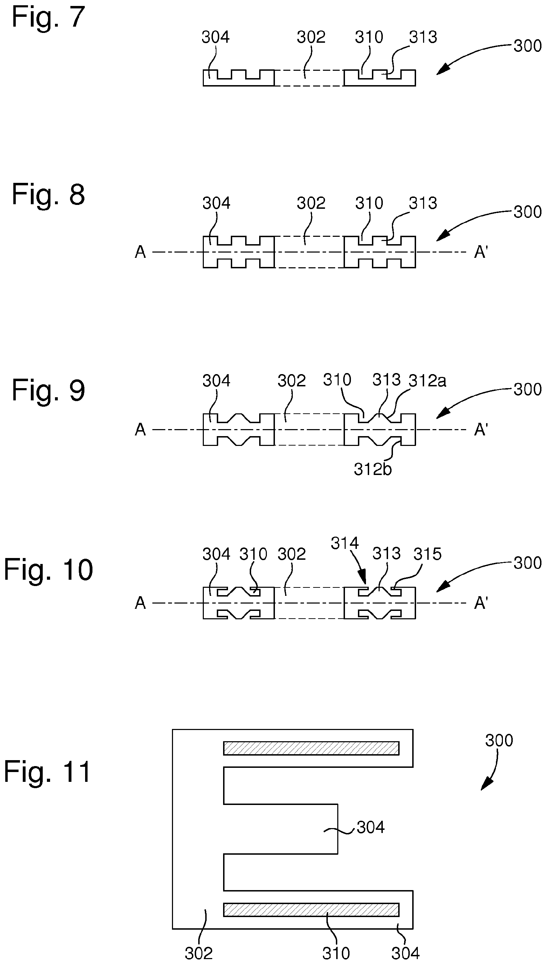

Dans une deuxième forme d'exécution, qui ne fait pas partie de l'invention, il est prévu d'avoir au moins deux gorges 310 sur l'une des faces 314, 316 de chaque bras 304 comme visible à la figure 7. De préférence, les au moins deux gorges 310 d'un bras 304 sont placées sur la même face 314, 316 que les au moins deux gorges 310 de l'autre bras 304. Cette disposition permet d'optimiser les champs électriques dans le résonateur 300.

Cette deuxième forme d'exécution peut avoir une variante en ce que chaque face 314, 316 de chaque bras 304 comprend au moins deux gorges 310 comme visible à la figure 8.

Cette variante peut consister à avoir deux rainures comprenant chacune un flanc droit 312b et un flanc incliné 312a, ces deux gorges 310 étant séparées par un élément central 313 comme visible à la figure 9. Ces rainures sont agencées de sorte que l'élément central 313 soit formé par les flancs inclinés 312a des deux gorges 310. Ces flancs 312a ont inclinés de sorte que la surface de la gorge 310 diminue lorsque la profondeur augmente. Cette disposition permet de profiter des flancs droits 312b des gorges 310 pour augmenter le couplage. De plus, le fait d'avoir deux petites gorges 310 au lieu d'une gorge 310 très large permet de ne pas enlever trop de matière au résonateur 300 et ainsi de moins le fragiliser.

Cette deuxième forme d'exécution et sa variante ont également l'avantage de permettre de raccourcir la durée du procédé car il y a moins de matière à enlever et donc moins de matière à modifier avec le laser (L).

Néanmoins, pour réaliser cette deuxième forme d'exécution, il est possible d'utiliser le procédé d'une autre façon. En effet, il a été décrit que le procédé utilise un laser (L) dont la durée des impulsions est de l'ordre de la femto-seconde pour modifier des zones du résonateur 300 et les dissoudre par action chimique. Or, il est également possible d'utiliser le laser (L) pour découper le résonateur 300. Le laser (L) est utilisé pour modifier les contours d'une zone à supprimer. L'étape de gravure chimique est alors effectuée et cela permet de dissoudre les contours de la zone à supprimer. Comme les contours de cette dernière sont dissous par l'action de l'agent chimique, la zone à supprimer se détache du résonateur 300. On peut alors sculpter la surface du résonateur 300 et enlever une partie de celui-ci, pour faire par exemple les gorges 310, sans modifier la structure de toute cette partie. Le gain de temps est, par conséquent, significatif.

Dans une seconde variante visible à la figure 10, chaque gorge 310 comprend une portion relativement grande en surface 314. Ces portions en surface 314 se présentent sous la forme d'une saillie 315 située à la surface du résonateur 300. Cette saillie 315 présente un profil rectangulaire et s'étend en direction du centre des bras. Cet agencement permet, outre les avantages d'avoir un champ électrique optimisé, d'améliorer l'alignement des masques. En effet, dans le cas de cette deuxième forme d'exécution, les portions en surface 314 sont utilisées pour augmenter la distance entre les électrodes 308 latérales et celles placées au centre des bras du diapason. On obtient alors une plus grande précision ou tolérance d'alignement des différents masques et donc une augmentation de la fiabilité et du rendement du procédé. On comprend donc que le résonateur, les gorges 310 et les portions en surface 314 sont réalisés préalablement à l'étape de réalisation des électrodes. La méthode permet d'utiliser une méthode de masquage par ombrage ou par spray photosensible.

Dans une troisième forme d'exécution visible à la figure 11, qui ne fait pas partie de l'invention, il est possible que le résonateur 300 comprenne un troisième bras 304 de sorte que le résonateur 300 ait une forme similaire à celle d'un trident. Ce troisième bras 304 est utilisé pour la fixation du résonateur 300 et plus particulièrement pour modifier son centre de gravité. En effet, ce troisième bras 304 est utilisé comme point de fixation de sorte qu'il soit en contact du socle 306 soutenant le résonateur 300. Cette disposition du troisième bras 304 qui fait office de bras central 304 permet de positionner le centre de gravité et afin d'avoir le meilleur équilibre du résonateur 300. Bien entendu, ce résonateur 300 à trois bras 304 peut être agencé pour présenter une forme qui ressemble sensiblement à celle de la lettre W ou de la lettre M.

Avantageusement, le procédé peut ne pas être utilisé que pour réaliser les gorges 310 des bras 304 du résonateur 300. En effet, comme le procédé est précis et permet de réaliser des formes complexes, son utilisation pour réaliser une partie ou la totalité du résonateur 300 à partir d'un substrat est également envisageable. Cette possibilité de réaliser tout le résonateur 300 avec le procédé est avantageuse car elle permet de raccourcir la durée du procédé. L'utilisation de ce procédé permet de réaliser, en une seule étape, l'étape de réalisation des contours et l'étape de réalisation des gorges 310 du résonateur 300. Bien entendu, on comprendra que cette façon de faire est aussi utilisable pour le cas d'un résonateur 300 standard à deux bras 304. Par ailleurs, il est envisageable que le procédé ne soit utilisé que pour réaliser un résonateur 300 à deux ou trois bras 304 ne présentant pas de gorges 310 sur l'un et/ou l'autre des bras 304. Un autre avantage de cette technique réside dans la possibilité de s'affranchir des résidus de gravure chimique entre les deux bras et, quand des palmes sont agencées au bout des bras 304, à la base des palmes.

En effet, la gravure chimique par photolithographie et attaque chimique présente l'inconvénient d'être peu précise car l'attaque chimique ne se contrôle pas parfaitement. De ce fait, il est constaté qu'au niveau des certaines parties d'une pièce à réaliser du type résonateur, des résidus de gravure subsistent. Par exemple, on constate sur la figure 2 représentant un résonateur réalisé par la méthode de photolithographie et gravure chimique, que des résidus de gravure 502 subsistent dans la zone 500 située entre les deux bras 304 ou à la base des palmes de la zone des palmes 501. Or, ces résidus peuvent entraîner un déséquilibre de la pièce puisque la répartition de matière n'est pas forcement parfaite.

Au contraire, avec le procédé, l'illumination des contours avec le laser femtoseconde est précise ce qui a pour avantage d'avoir une gravure précise et mieux contrôlable et ainsi d'équilibrer les bras. Il est alors possible d'obtenir un résonateur 300 dont tous les flancs 311, 312 sont droits et verticaux et dont tous les angles sont vifs peu importe qu'ils soient droits ou non comme visible à la figure 4.

Le résonateur selon l'invention se présente sous la forme d'un résonateur balancier-spiral. Ce balancier spiral comprend un volant d'inertie appelé balancier sur lequel est monté co-axialement un ressort spiral. Le balancier comprend une masse annulaire appelée serge tenue par au moins deux bras et le ressort spiral comprend un corps 100 qui se présente sous la forme d'un barreau 5 enroulé sur lui même pour former un spiral 400 comme visible à la figure 13. Un tel spiral 400 peut être fabriqué en utilisant le procédé selon l'invention. Pour cela, les contours du spiral 400 sont dessinés sur un substrat en utilisant le laser (L) dont la durée des impulsions est de l'ordre de la femto-seconde ou picoseconde. L'étape de gravure chimique permet alors de désolidariser le spiral 400 du reste du substrat.

L'avantage du procédé selon la présente invention est de permettre de réaliser précisément la forme désirée pour le spiral 400. Ce procédé permet également d'obtenir un spiral ayant des flancs droits sur la totalité de sa longueur c'est-à-dire avoir localement des flancs parallèles. Cela évite ainsi la présence de surplombs selon certaines orientations cristallographiques présentes après une technique classique de gravure chimique, et permet ainsi un meilleur équilibre du résonateur spiral.

Par ailleurs, le procédé utilisé permet, grâce à la précision des formes obtenues, de réaliser les formes les plus complexes comme par exemple un spiral de type Breguet. Un tel spiral se distingue en présentant une courbe terminale de type Phillips c'est-à-dire une courbe terminale qui s'élève. On obtient alors un ressort spiral en trois dimensions. Ainsi, avec le procédé selon la présente invention, il est aisé de dessiner les contours du ressort spiral de type Breguet avec le laser (L) dont la durée des impulsions est de l'ordre de la femto-seconde.

Le procédé selon la présente invention permet également de faciliter le réglage du résonateur 300. En effet, les deux grandes caractéristiques d'un résonateur balancier-spiral sont la fréquence et l'isochronisme c'est-à-dire la capacité d'un résonateur 300 à avoir une durée des oscillations indépendantes de l'amplitude de celles-ci et de la position de la montre. Pour régler la fréquence et l'isochronisme d'un résonateur balancier-spiral, la modification locale de la rigidité du spiral est une solution. Pour se faire, la précision du procédé selon l'invention est utile car elle permet de réaliser des évidements 310 ou gorges ou baignoires le long des spires du résonateur spiral. Ces évidements ou gorges ou baignoires sont réalisés localement de sorte à diminuer localement la rigidité du résonateur et profitent des avantages de précision du procédé. Ces évidements 310 présentent au moins deux flancs droits, parallèles, mais il est possible que les flancs soient parallèles deux à deux. Les flancs des évidements peuvent aussi être localement parallèles. Le procédé permet donc de réaliser les contours et les évidements 310 du résonateur spiral dans une seule et même étape simplifiant en conséquence la fabrication d'un tel résonateur spiral.

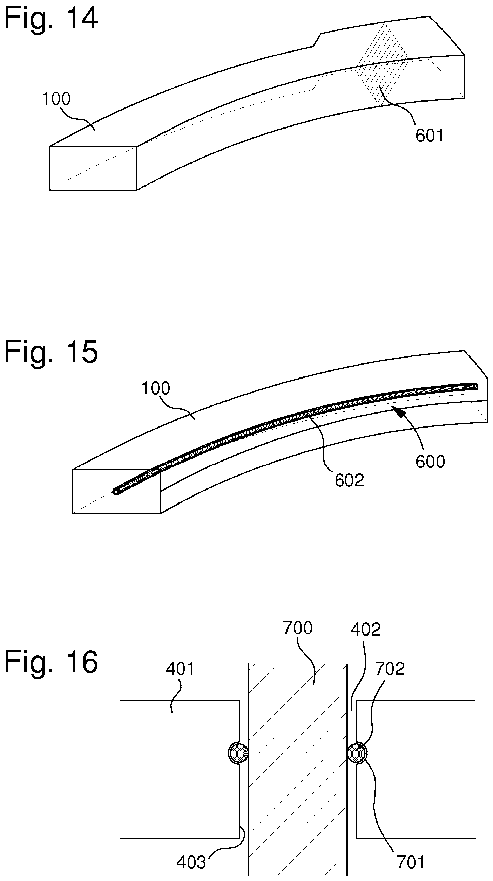

Dans une variante, il est envisagé que le spiral, réalisé dans un matériau transparent pour le laser, puisse être illuminé. Pour cela, un dispositif lumineux est placé à proximité d'un endroit du ressort spiral 400, de préférence à l'une des extrémités. La lumière émise par le dispositif est alors diffusée dans le spiral. Le procédé selon l'invention permettant de modifier la structure interne du corps 100 du résonateur spiral par le laser permet donc de modifier localement l'indice de réfraction de la matière. Cette caractéristique permet de réaliser des structures internes 600. Ces structures internes 600 peuvent être des miroirs 601 « conventionnels » ou d'utiliser les systèmes de cristaux photoniques en deux ou trois dimensions comme visible à la figure 14.

Cette modification de l'indice de réfraction de la matière peut être réalisée de sorte à former un guide de lumière 602 visible à la figure 15. Pour cela, la matière est modifiée de sorte à former un canal de section carré ou circulaire pouvant parcourir une partie ou la totalité de la spire.

De même, il peut être envisagé que le procédé d'illumination laser et gravure chimique puisse être utilisé pour améliorer la fixation dudit résonateur spiral comme visible à la figure 16. En effet, un résonateur spiral 400 est fixé sur un axe 700 par l'intermédiaire d'une virole 401 pouvant venir de matière avec le corps 100 enroulé pour former une spire. Cette virole est située à l'extrémité intérieure du corps 100 de sorte à être au centre du résonateur spiral 400. Cette virole 401 comprend un trou traversant 402 pouvant être circulaire ou rectangulaire dans lequel l'axe 700 s'insère. Pour améliorer la fixation, au moins un évidement ou une gorge 701 peut être réalisé au niveau des flancs 403 du trou 402 pour qu'un élément intermédiaire 702 puisse s'insérer entre la virole et l'axe lors de la fixation dudit résonateur spiral. Cet élément intermédiaire peut être métallique ou se présenter sous la forme d'un joint O-ring.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

## Revendications

1. Procédé de fabrication d'un résonateur spiral (300, 400) dans un substrat, ledit résonateur comprenant un volant d'inertie couplé à un corps (100) formé d'un barreau enroulé sur lui-même pour former un spiral, ledit corps ayant des flancs droits sur la totalité de sa longueur, les flancs étant localement parallèles, ledit corps comprenant au moins une creusure (310) pour modifier localement la rigidité et ainsi ajuster la fréquence du résonateur et/ou régler le défaut d'isochronisme, comprenant les étapes suivantes :
a) modifier la structure d'au moins une zone du substrat afin de rendre plus sélective ladite au moins une zone ;
b) graver ladite au moins une zone afin de sélectivement fabriquer ledit résonateur spiral.

2. Procédé selon la revendication 1, **caractérisé en ce que** ladite au moins une creusure comprend au moins deux flancs parallèles et verticaux.

3. Procédé selon les revendications 1 ou 2, **caractérisé en ce que** ledit corps est réalisé en quartz ou céramique ou verre et **en ce qu'**il comprend des flancs localement parallèles et verticaux sur tout la longueur dudit corps.

4. Procédé selon l'une des revendications 1 à 3, **caractérisé en ce que** ledit corps comprend une courbe terminale surélevée par rapport au plan des autres spires formées par le barreau enroulé sur lui-même

5. Procédé selon l'une des revendications 1 à 4, **caractérisé en ce que caractérisé en ce que** ledit corps (100) transmet et diffuse de la lumière émise par au moins une source d'énergie lumineuse.

6. Procédé selon la revendication 5, **caractérisé en ce que** la structure dudit corps (100) est modifié par laser de sorte à modifier localement l'indice de réfraction de la matière.

7. Procédé selon la revendication 5, **caractérisé en ce que** la structure dudit corps (100) dont l'indice de réfraction de la matière est modifié par laser est utilisée pour former un miroir.

8. Procédé selon la revendication 5, **caractérisé en ce que** la structure dudit corps (100) dont l'indice de réfraction de la matière est modifié par laser est utilisée pour former un guide de lumière.

9. Procédé de fabrication selon l'une des revendications précédentes, **caractérisé en ce qu'**il comprend en outre l'étape :
c) libérer le résonateur dudit substrat.

10. Procédé de fabrication selon l'une des revendications précédentes, **caractérisé en ce que** la structure de ladite au moins une zone est modifiée par un laser (L).

11. Procédé de fabrication selon l'une des revendications précédentes, **caractérisé en ce que** le substrat est réalisé en matériau transparent à la longueur d'onde du laser.

12. Procédé de fabrication selon les revendications 10 ou 11, **caractérisé en ce que** la durée des impulsions du laser (L) vont de la femtoseconde à la picoseconde.

13. Procédé de fabrication selon la revendication 11, **caractérisé en ce que** le substrat est réalisé en matériau monocristallin.

14. Procédé de fabrication selon la revendication 11, **caractérisé en ce que** le substrat est réalisé en matériau polycristallin.

15. Procédé de fabrication selon la revendication 11, **caractérisé en ce que** le substrat est réalisé en polymère.

16. Procédé de fabrication selon la revendication 11, **caractérisé en ce que** le substrat est réalisé en un matériau amorphe comme une céramique ou un verre.

17. Résonateur spiral (400) comprenant un volant d'inertie couplé à un corps (100) réalisé en quartz ou céramique ou verre formé d'un barreau enroulé sur lui-même pour former un spiral **caractérisé en ce que** ledit corps comprend au moins une creusure (310) pour modifier localement la rigidité et ainsi ajuster la fréquence du résonateur et/ou régler le défaut d'isochronisme, **caractérisé en ce que** ledit corps a des flancs droits sur la totalité de sa longueur, les flancs étant localement parallèles et verticaux.

18. Résonateur (400) selon la revendication 17, **caractérisé en ce que**, ladite au moins une creusure comprend au moins deux flans parallèles et verticaux.

19. Résonateur selon la revendication 17 ou 18, **caractérisé en ce que** ledit corps comprend une courbe terminale surélevée par rapport au plan des autres spires formées par le barreau enroulé sur lui-même

20. Résonateur selon l'une des revendications 17 à 19, **caractérisé en ce que** ledit corps (100) transmet et diffuse de la lumière émise par au moins une source d'énergie lumineuse.

21. Résonateur selon la revendication 20, **caractérisé en ce que** la structure dudit corps (100) est modifié par laser de sorte à modifier localement l'indice de réfraction de la matière.

22. Résonateur selon la revendication 17, **caractérisé en ce que** la structure dudit corps (100) dont l'indice de réfraction de la matière est modifié par laser est utilisée pour former un miroir.

23. Résonateur selon la revendication 21, **caractérisé en ce que** la structure dudit corps (100) dont l'indice de réfraction de la matière est modifié par laser est utilisée pour former un guide de lumière.

24. Résonateur (400) selon l'une des revendications 17 à 23, **caractérisé en ce qu'**il comprend en outre une virole (401) venant de matière avec ledit corps (100), ladite virole comprenant un trou (402) agencé pour que ledit résonateur soit monté sur un axe (700), **en ce que** le trou (402) présente au moins un flanc (403) sur lesquels au moins une gorge (701) est agencée de sorte qu'un élément intermédiaire (702) puisse s'insérer entre la virole et l'axe.

## Patentansprüche

1. Verfahren zur Herstellung eines Spiralresonators (300, 400) in einem Substrat, wobei der Resonator ein Trägheitsschwungrad umfasst, das an einen Körper (100) gekoppelt ist, der aus einem Stab gebildet ist, der um sich selbst gewickelt ist, um eine Spirale zu bilden, wobei der Körper gerade Flanken über seine gesamte Länge aufweist, wobei die Flanken lokal parallel sind, wobei der Körper mindestens eine Vertiefung (310) umfasst, um die Starrheit lokal zu verändern und somit die Frequenz des Resonators anzupassen und/oder den Isochronismusfehler zu regeln, die folgenden Schritte umfassend:
a) Ändern der Struktur mindestens einer Zone des Substrats, um die mindestens eine Zone selektiver zu gestalten;
b) Gravieren der mindestens einen Zone, um den Spiralresonator selektiv herzustellen.

2. Verfahren nach Anspruch 1, **dadurch gekennzeichnet, dass** die mindestens eine Vertiefung mindestens zwei parallele und vertikale Flanken umfasst.

3. Verfahren nach den Ansprüchen 1 oder 2, **dadurch gekennzeichnet, dass** der Körper aus Quarz oder Keramik oder Glas realisiert ist, und dadurch, dass er lokal parallele und vertikale Flanken über die gesamte Länge des Körpers umfasst.

4. Verfahren nach einem der Ansprüche 1 bis 3, **dadurch gekennzeichnet, dass** der Körper eine in Bezug auf die Ebene der anderen durch den um sich selbst gewickelten Stab gebildeten Windungen angehobene Abschlusskurve umfasst.

5. Verfahren nach einem der Ansprüche 1 bis 4, **dadurch gekennzeichnet, dass** der Körper (100) Licht überträgt und ausstrahlt, das durch mindestens eine Lichtenergiequelle ausgegeben wird.

6. Verfahren nach Anspruch 5, **dadurch gekennzeichnet, dass** die Struktur des Körpers (100) durch Laser derart geändert wird, um den Brechungsindex des Materials lokal zu ändern.

7. Verfahren nach Anspruch 5, **dadurch gekennzeichnet, dass** die Struktur des Körpers (100), dessen Brechungsindex des Materials durch Laser geändert wird, verwendet wird, um einen Spiegel zu bilden.

8. Verfahren nach Anspruch 5, **dadurch gekennzeichnet, dass** die Struktur des Körpers (100), dessen Brechungsindex des Materials durch Laser geändert wird, verwendet wird, um einen Lichtleiter zu bilden.

9. Verfahren zur Herstellung nach einem der vorstehenden Ansprüche, **dadurch gekennzeichnet, dass** es weiter den folgenden Schritt umfasst:
c) Freigeben des Resonators aus dem Substrat.

10. Verfahren zur Herstellung nach einem der vorstehenden Ansprüche, **dadurch gekennzeichnet, dass** die Struktur der mindestens einen Zone durch einen Laser (L) geändert wird.

11. Verfahren zur Herstellung nach einem der vorstehenden Ansprüche, **dadurch gekennzeichnet, dass** das Substrat aus einem für die Wellenlänge des Lasers durchsichtigen Material realisiert ist.

12. Verfahren zur Herstellung nach einem der Ansprüche 10 oder 11, **dadurch gekennzeichnet, dass** die Dauer der Impulse des Lasers (L) von der Femtosekunde zur Picosekunde reicht.

13. Verfahren zur Herstellung nach Anspruch 11, **dadurch gekennzeichnet, dass** das Substrat aus einem mikrokristallinen Material realisiert ist.

14. Verfahren zur Herstellung nach Anspruch 11, **dadurch gekennzeichnet, dass** das Substrat aus einem polykristallinen Material realisiert ist.

15. Verfahren zur Herstellung nach Anspruch 11, **dadurch gekennzeichnet, dass** das Substrat aus Polymer realisiert ist.

16. Verfahren zur Herstellung nach Anspruch 11, **dadurch gekennzeichnet, dass** das Substrat aus einem amorphen Material, wie Keramik oder Glas realisiert ist.

17. Spiralresonator (400), umfassend ein Trägheitsschwungrad, das an einen Körper (100) gekoppelt ist, der aus Quarz oder Keramik oder Glas realisiert ist, der aus einem Stab gebildet ist, der um sich selbst gewickelt ist, um eine Spirale zu bilden, **dadurch gekennzeichnet, dass** der Körper mindestens eine Vertiefung (310) umfasst, um die Starrheit lokal zu verändern und somit die Frequenz des Resonators anzupassen und/oder den Isochronismusfehler zu regeln, **dadurch gekennzeichnet, dass** der Körper gerade Flanken über seine gesamte Länge aufweist, wobei die Flanken lokal parallel und vertikal sind.

18. Resonator (400) nach Anspruch 17, **dadurch gekennzeichnet, dass** die mindestens eine Vertiefung mindestens zwei parallele und vertikale Flanken umfasst.

19. Resonator (400) nach Anspruch 17 oder 18, **dadurch gekennzeichnet**, der Körper eine in Bezug auf die Ebene der anderen durch den um sich selbst gewickelten Stab gebildeten Windungen angehobene Abschlusskurve umfasst.

20. Resonator nach einem der Ansprüche 17 bis 19, **dadurch gekennzeichnet**, der Körper (100) Licht überträgt und ausstrahlt, das durch mindestens eine Lichtenergiequelle ausgegeben wird.

21. Resonator nach Anspruch 20, **dadurch gekennzeichnet, dass** die Struktur des Körpers (100) durch Laser derart geändert wird, um den Brechungsindex des Materials lokal zu ändern.

22. Resonator nach Anspruch 17, **dadurch gekennzeichnet, dass** die Struktur des Körpers (100), dessen Brechungsindex des Materials durch Laser geändert wird, verwendet wird, um einen Spiegel zu bilden.

23. Resonator nach Anspruch 21, **dadurch gekennzeichnet, dass** die Struktur des Körpers (100), dessen Brechungsindex des Materials durch Laser geändert wird, verwendet wird, um einen Lichtleiter zu bilden.

24. Resonator nach einem der Ansprüche 17 bis 23, **dadurch gekennzeichnet, dass** er weiter eine Spiralrolle (401) umfasst, die aus einem Stück mit dem Körper (100) gefertigt ist, wobei die Spiralrolle ein Loch (402) umfasst, das angeordnet ist, damit der Resonator auf einer Achse (700) montiert wird, dadurch, dass das Loch (402) mindestens eine Flanke (403) aufweist, auf denen mindestens eine Nut (701) derart angeordnet ist, dass ein Zwischenelement (702) zwischen die Spiralrolle und die Achse eingeführt werden kann.

## Claims

1. A method for manufacturing a spiral resonator (300, 400) in a substrate, said resonator comprising a flywheel coupled to a body (100) formed of a bar wound on itself to form a balance spring, said body having straight sides over its entire length, the sides being locally parallel, said body comprising at least one recess (310) for locally modifying the rigidity and thus adjusting the frequency of the resonator and/or regulating the isochronism defect, comprising the following steps:
a) modifying the structure of at least one area of the substrate in order to make said at least one area more selective;
b) etching said at least one area in order to selectively manufacture said spiral resonator.

2. The method according to claim 1, **characterised in that** said at least one recess comprises at least two parallel and vertical sides.

3. The method according to claims 1 or 2, **characterised in that** said body is made of quartz or ceramic or glass and **in that** it comprises locally parallel and vertical sides over the entire length of said body.

4. The method according to one of claims 1 to 3, **characterised in that** said body comprises an end curve raised relative to the plane of the other turns formed by the bar wound on itself.

5. The method according to one of claims 1 to 4, **characterised in that** said body (100) transmits and diffuses light emitted by at least one light energy source.

6. The method according to claim 5, **characterised in that** the structure of said body (100) is modified by laser so as to locally modify the refractive index of the material.

7. The method according to claim 5, **characterised in that** the structure of said body (100) whose refractive index of the material is modified by laser is used to form a mirror.

8. The method according to claim 5, **characterised in that** the structure of said body (100) whose refractive index of the material is modified by laser is used to form a light guide.

9. The manufacturing method according to one of the preceding claims, **characterised in that** it further comprises the step:
c) releasing the resonator from said substrate.

10. The manufacturing method according to one of the preceding claims, **characterised in that** the structure of said at least one area is modified by a laser (L).

11. The manufacturing method according to one of the preceding claims, **characterised in that** the substrate is made of a material transparent to the laser wavelength.

12. The manufacturing method according to claims 10 or 11, **characterised in that** the duration of the laser pulses (L) range from femtosecond to picosecond.

13. The manufacturing method according to claim 11, **characterised in that** the substrate is made of monocrystalline material.

14. The manufacturing method according to claim 11, **characterised in that** the substrate is made of polycrystalline material.

15. The manufacturing method according to claim 11, **characterised in that** the substrate is made of polymer.

16. The manufacturing method according to claim 11, **characterised in that** the substrate is made of an amorphous material such as a ceramic or a glass.

17. A spiral resonator (400) comprising a flywheel coupled to a body (100) made of quartz or ceramic or glass formed of a bar wound on itself to form a balance spring **characterised in that** said body comprises at least one recess (310) for locally modifying the rigidity and thus adjusting the frequency of the resonator and/or regulating the isochronism defect, **characterised in that** said body has straight sides over its entire length, the sides being locally parallel and vertical.

18. The resonator (400) according to claim 17, **characterised in that** said at least one recess comprises at least two parallel and vertical sides.

19. The resonator according to claim 17 or 18, **characterised in that** said body comprises an end curve raised relative to the plane of the other turns formed by the bar wound on itself.

20. The resonator according to one of claims 17 to 19, **characterised in that** said body (100) transmits and diffuses light emitted by at least one light energy source.

21. The resonator according to claim 20, **characterised in that** the structure of said body (100) is modified by laser so as to locally modify the refractive index of the material.

22. The resonator according to claim 17, **characterised in that** the structure of said body (100) of which the refractive index of the material is modified by laser is used to form a mirror.

23. The resonator according to claim 21, **characterised in that** the structure of said body (100) of which the refractive index of the material is modified by laser is used to form a light guide.

24. The resonator (400) according to one of claims 17 to 23, **characterised in that** it further comprises a collet (401) integral with said body (100), said collet comprising a hole (402) arranged so that said resonator is mounted on a shaft (700), **in that** the hole (402) has at least one side (403) on which at least one groove (701) is arranged so that an intermediate element (702) can be inserted between the collet and the shaft.
